Europäisches Patentamt

European Patent Office

Office européen des brevets

(11) Veröffentlichungsnummer: **0 062 099**
**B1**

(12) # EUROPÄISCHE PATENTSCHRIFT

(45) Veröffentlichungstag der Patentschrift:
15.10.86

(51) Int. Cl.⁴: **H 01 L 29/743**, H 01 L 29/08

(21) Anmeldenummer: **81108714.7**

(22) Anmeldetag: **22.10.81**

(54) **Thyristor und Verfahren zu seinem Betrieb.**

(30) Priorität: **31.03.81 DE 3112942**

(43) Veröffentlichungstag der Anmeldung:
**13.10.82 Patentblatt 82/41**

(45) Bekanntmachung des Hinweises auf die Patenterteilung:
**15.10.86 Patentblatt 86/42**

(84) Benannte Vertragsstaaten:
**CH FR GB IT LI SE**

(56) Entgegenhaltungen:
**EP-A-0 030 274**
**DE-A-2 947 669**
**GB-A-2 070 330**

(73) Patentinhaber: **Siemens Aktiengesellschaft Berlin
und München, Wittelsbacherplatz 2, D-8000
München 2 (DE)**

(72) Erfinder: **Herberg, Helmut, Dr., Kobellstrasse 12,
D-8000 München 2 (DE)**

**Beschreibung**

Die Erfindung bezieht sich auf einen Thyristor nach dem Oberbegriff des Patentanspruchs 1 und auf Verfahren zu seinem Betrieb.

Aus der DE—AS 24 38 894 ist ein Thyristor dieser Art bekannt, bie dem der n-Emitter von mehreren Ansätzen der angrenzenden Basisschicht durchdrungen wird, die sich bis zur Grenzfläche des Halbleiterkörpers estrecken und in dieser mit der Kathode leitend verbunden sind. Diese Ansätze werden auch als feste Emitterkurzschlüsse bezeichnet. Durch eine Mehrzahl von solchen Emitterkurzschlüssen wird eine gute Stabilität des Thyristors ereicht, d.h. eine große Sicherheit gegen unbeabsichtigte Zündvorgänge beim Auftreten von in Durchlaßrichtung gepolten Spannungen an der Anoden-Kathoden-Strecke, die teilweise sehr schnell ansteigen (hohe dU/dt-Belastung). Andererseits verringert sich wegen der festen Emitterkurzschulüsse die Zündempfindlichkeit des Thyristors.

In der deutschen Patentanmeldung P 29 45 366.5 wird ein Thyristor der eingangs genannten Art beschrieben, bie dem steuerbare Emitterkurzschlüsse in Form von gategesteuerten FET-Strukturen an der die Kathode (Anode) tragenden Grenzfläche des Halbleiterkörpers vorgesehen sind. Bei eingeschalteten, d. h. wirksamen, Emitterkurzschlüssen wird hierbei einerseits eine große Stabilität erreicht, während andererseits durch eine Unwirksamschaltung der Emitterkurzschlüsse die Zündempfindlichkeit des Thyristors etwa auf einen Wert gebracht wird, der ohne die steuerbaren Emitterkurzschlüsse vorhanden wäre.

Der Erfindung liegt die Aufgabe zugrunde, einen Thyristor der eingangs genennten Art anzugeben, bei dem die sich widersprechenden Forderungen nach einer guten Stabilität und einer großen Zündempfindlichkeit noch besser erfüllt sind als bei den vorstehend beschriebenen Thyristoren. Das wird erfindungsgemäß durch eine Ausbildung des Thyristors gemäß dem kennzeichnenden Teil des Patentanspruchs 1 erreicht.

Der mit der Erfindung erzielbare Vorteil liegt insbesondere darin, daß der anschaltbare n(p)-Emitter einerseits im nichtleitenden Zustand des Halbleiterschalters wegen der dann fehlenden Verbindung zum n(p)-Emitter und damit zur Kathode (Anode) die Stabilität des Thyristors nicht verringert, während er andererseits im leitenden Zustand des Halbleiterschalters die Zündempfindlichkeit des Thyristors ganz wesentlich vergrößert. Im einzelnen steigt die Zündempfindlichkeit in dem Maße, in dem der Stromverstärkungsfaktor der den anschaltbaren n(p)-Emitter und die beiden Basisschichten umfassenden Drei-Schichten-Struktur für die von dem anschaltbaren n(p)-Emitter emittierten Ladungsträger größer ist als der entsprechende Stromverstärkungsfaktor der den n(p)-Emitter und die beiden Basisschichten umfassenden Drei-Schichten-Struktur.

Die Patentansprüche 2 bis 11 sind auf bevorzugte Ausgestaltungen und Weiterbildungen der Erfindung gerichtet, während die Patentansprüche 12 und 13 vorteilhafte Verfahren zum Betrieb des erfindungsgemäßen Thyristors angeben.

Die Erfindung wird nachfolgend anhand der Zeichnung näher beschrieben. Dabei zeigt:

Fig. 1 den Querschnitt eines ersten Ausführungsbeispiels der Erfindung,

Fig. 2 den Querschnitt eines zweiten Ausführungsbeispiels,

Fig. 3 den Querschnitt eines dritten Ausführungsbeispiels,

Fig. 4 den Querschnitt eines vierten Ausführungsbeispiels und

Fig. 5 die schematische Darstellung einer alternativen Ausführungsform zu Fig. 1.

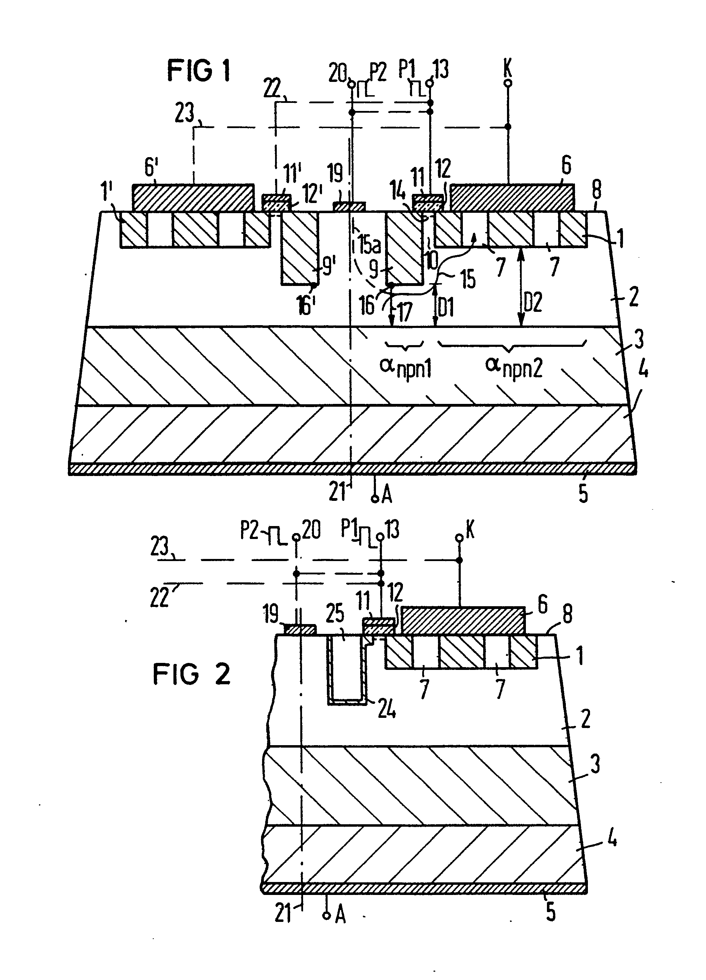

In Fig. 1 ist ein Thyristor dargestellt, der einen aus dotiertem Halbleitermaterial, z. B. Silizium, bestehenden Halbleiterkörper mit vier Schichten abwechselnder Leitungstypen aufweist. Dabei bezeichnet man die n-leitende Schicht 1 als den n-Emitter, die p-leitende Schicht 2 als die p-Basis, die n-leitende Schicht 3 als die n-Basis und die p-leitende Schicht 4 als den p-Emitter. Der p-Emitter 4 ist mit einer Anode 5 versehen, die einen Anschluß A hat, während der n-Emitter 1 eine Kathode 6 mit einem Anschluß K aufweist.

Der n-Emitter 1 wird von mehreren Ansätzen 7 der p-Basis 2 durchdrungen, die sich bis zur Grenzfläche 8 des Halbleiterkörpers erstrecken und in dieser mit der Kathode 6 leitend verbunden sind. Die Ansätze 7 stellen sog. feste Emitter-Kurzschlüsse dar, die eine unbeabsichtigte Zündung des Thyristors beim Anlegen einer Blockierspannung an die Anschlüsse A und K, die die Anode 5 auf ein positiveres Potential legt als die Kathode 6, weitgehend verhindern. Dies erklärt sich daraus, daß die unter dem Einfluß der Blockierspannung in Richtung auf den n-Emitter 1 transportierten Defektelektronen zum größten Teil nicht zu dem pn-Übergang zwischen den Teilen 1 und 2 gelangen, sondern über die Ansätze 7 direkt zur Kathode 6, so daß die keine Emission von Elektronen aus dem n-Emitter 1 auslösen. Mit wachsender Anzahl der festen Emitterkurzschlüsse 7 ist der Thyristor auch gegenüber größeren oder schnell ansteigenden Blockierspannungen an den Anschlüssen A, K zündunempfindlich, d. h. stabil.

Ein n-leitendes Gebiet 9 erstreckt sich, ausgehend von der Grenzfläche 8, wesentlich tiefer in die p-Basis 2 hinein als als der n-Emitter 1 und wird durch eine Diffusion oder Implantation von Donatoren in die Schicht 2 erzeugt. Das Gebiet 9 ist lateral neben dem n-Emitter 1 vorgesehen, wobei zu diesem ein Abstand besteht, der durch die Breite eines Bereichs 10 der p-Basis 2 bestimmt ist. Der Bereich 10 wird durch ein metallisches oder aus Polysilizium bestehendes Gate 11 überdeckt, das durch eine dünne, elektrische isolierende Schicht 12, z. B. aus $SiO_2$, von der Grenzfläche 8 getrennt ist. Das Gate 11 ist mit einem Steuerspannungsanschluß 13 verbunden. Die einander zugekehrten Randbereiche des n-Emitters 1 und des Gebiets 9 bilden zusammen mit dem Bereich 10, der isolierenden Schicht 12 und dem Gate 11 einen Feldeffekttransistor des Anreicherungstyps. Beim Anlegen einer gegenüber K positiven, den Wert der Einsatzspannung übersteigenden Steuerspannung an den Anschluß 13 bildet sich an der Grenzfläche 8 unterhalb von 11 ein Inversionskanal aus, der mit 14 angedeutet ist. Dieser n-leitende Kanal stellt eine niederohmige Verbindung zwischen dem Gebiet 9 und dem n-Emitter 1 bzw. der Kathode 6 her. Wird die Steuerspannung vom Anschluß 13 abgeschaltet, so wird der Kanal 14 beseitigt und die Verbindung zwischen dem Gebiet 9 und dem n-Emitter 1 unterbrochen. Die aus den Teilen 1, 9, 10, 11 und 12 gebildete Struktur stellt also einen Halbleiterschalter dar, der in einem ersten Schaltzustand das Gebiet 9 niederohmig mit der Kathode 6 verbindet, so daß ein vergrößerter n-Emitter 1, 9 entsteht, während er in einem zweiten Schaltzustand das Gebiet 9 von der Kathode 6 abtrennt, so daß 9 keine Emitterfunktion ausüben kann. Im folgenden wird das Gebiet 9 als anschaltbarer n-Emitter bezeichnet.

Ausgehend von der Grenzfläche 8 beträgt die Eindringtiefe des anschaltbaren n-Emitters 9 in die p-Basis 2 bei dem in Fig. 1 dargestellten Ausführungsbeispiel mehr als das Doppelte der Eindringtiefe des n-Emitters 1. Nimmt man für den n-Emitter 1 eine Eindringtiefe von etwa 20 µm an, so beträgt die Eindringtiefe von 9 beispielsweise 50 µm. Dementsprechend ist der Abstand D1 des anschaltbaren n-Emitters 9 vom pn-Übergang zwischen den Basisschichten 2 und 3 kleiner als der Abstand D2 des n-Emitters 1 von diesem Übergang.

Nachfolgend wird die Zündung des Thyristors nach Fig. 1 erläutert. Dabei wird davon ausgegangen, daß eine den Thyristor in Durchlaßrichtung polende Spannung an den Anschlüssen A und K liegt und dem Anschluß 13 eine positive Steuerspannung zugeführt wird. Unter dem Einfluß der erstgenannten Spannung bewegen sich beispielsweise thermisch erzeugte Defektelektronen längs des in Fig. 1 eingezeichneten Weges 15 in Richtung auf einen festen Emitterkurzschluß 7, so daß bei leitendem Kanal 14 am Punkt 16 ein Spannungsabfall entsteht, der den pn-Übergang zwischen dem angeschalteten n-Emitter 9 und der p-Basis 2 soweit in Durchlaßrichtung vorspannt, daß an dieser Stelle Elektronen in die p-Basis 2 emittiert werden. Die von 9 emittierten Elektronen bewegen sich in Richtung des Pfeils 17, wobei ein Teil von ihnen die Grenzfläche zwischen der n-Basis 3 und dem p-Emitter 4 erreicht und eine Emission von Defektelektonen aus dem p-Emitter veranlaßt. Diese Emissionsvorgänge steigern sich gegenseitig, bis die Schichten 2 und 3 von emittierten Ladungsträgern überschwemmt sind, d. h. der Thyristor im Bereich des anschlatbaren n-Emitters 9 gezündet hat. Die gezündete Fläche des Thyristors breitet sich von 9 ausgehend in lateraler Richtung nach und nach auf den gesamten Bereich des n-Emitters 1 aus. Diese Ausbreitung, die unter anderem auf eine laterale Diffusion von Ladungsträgern aus dem bereits gezündeten Querschnittsteil zurückgeht, erfolgt beispielsweise mit einer Ausbreitungsgeschwindigkeit von 10 bis 100 µm/µs. Sobald der gezündete Teil des Thyristorquerschnitts den Bereich des n-Emitters 1 wenigstens teilweise umfasste, kann die Steuerspannung vom Anschluß 13 wieder abgeschaltet werden. Daher wird zweckmäßigerweise eine impulsförmige Steuerspannung P1 verwendet.

Für den Fall daß eine Zündelektrode 19 auf der p-Basis 2 angeordnet ist, erfolgt die Zündung des Thyristors bei kleineren Spannungen zwischen A und K als bei den vorstehenden Betrachtungen angenommen wurde mittels eines Zündstromimpulses P2, der über einen bei 20 angeschlossenen Zündstromkreis zugeführt wird. Die Vorspannung am Schaltungspunkt 16 wird hierbei von Defektelektronen erzeugt, die aus dem Halbleiterbereich unterhalb der Zündelektrode 19 stammen und über die in Fig. 1 eingezeichneten Wege 15a und 15 zu einem festen Kurzschluß 7 gelangen. Dabei wird der Anschluß 13 gleichzeitig mit der Steuerspannung P1 beschaltet. Zweckmäßigerweise werden die Anschlüsse 20 und 13 miteinander verbunden, wobei der Zünstromimpuls P2 am Anschluß 13 den Spannungsimpuls P1 abfallen läßt.

Der Thyristor wird gelöscht, wenn der Laststrom einen sog. Haltestrom unterschreitet. Das geschieht beispielsweise, wenn die Spannung von den Anschlüssen A und K abgeschaltet wird, oder, wenn es sich um eine Wechselspannung handelt, beim Auftreten des nächstfolgenden Nulldurchgangs.

Die große Zündempfindlichkeit des Thyristors nach Fig. 1 ergibt sich aus dem kleinen Abstand D1 zwischen dem anschaltbaren n-Emitter 9 und der Grenzfläche zwischen den Schichten 2 und 3. Der Stromverstärkungsfaktor $\alpha_{npn1}$ der aus den Teilen 9, 2 und 3 gebildeten npn-Struktur, der sich auf die von 9 emittierten Elektronen bezieht, ist wesentlich größer als der entsprechende Stromverstärkungsfaktor $\alpha_{npn2}$ für die aus den Teilen 1, 2 und 3 gebildete npn-Struktur. Dies erklärt sich daraus, daß die Rekombinationsrate der von 1 emittierten Elektronen wegen des größeren Abstandes D2 des n-Emitters 1 von der Grenzfläche zwischen 2 und 3 wesentlich größer ist als die Rekombinationsrate der von 9 emittierten Elektronen. Die Zündempfindlichkeit des Thyristors nach Fig. 1 ist also in dem Maße größer als die Zündempfindlichkeit eines herkömmlichen Thyristors, als der Stromverstärkungsfaktor $\alpha_{npn1}$ größer ist als $\alpha_{npn2}$.

Weist die p-Basis 2 ein Dotierungsprofil auf, bei dem der Dotierungsgrad im Bereich der unteren Begrenzungsfläche des anschaltbaren n-Emitters 9 kleiner ist als an der unteren Begrenzungsfläche des n-Emitters 1, so wird die am Punkt 16 herrschende Vorspannung des pn-Übergangs zwischen den Halbleiterteilen 2 und 9 gegenüber dem Fall, bei dem der Dotierungsgrad der p-Basis eine solche Verkleinerung nicht aufweist, weiter vergrößert, so daß die Zündempfindlichkeit im Bereich des anschaltbaren n-Emitters 9 weiter ansteigt.

Bisher wurde aus Gründen der besseren Übersicht das Erfindungspinrzip anhand des in Fig. 1 rechts von der vertikalen Mittellinie 21 liegenden Teils des dargestellten Thyristors erläutert. Geht man nun in Fig. 1 von einem rotationssymetrischen Aufbau des Thyristors mit der Linie 21 als Symetrieachse aus, so ergeben sich ringförmige Ausgestaltungen der Teile 1, 6, 9, 11 und 12. Die Schnittflächen dieser Schaltungsteile, die links von der Linie 21 liegen, werden in Fig. 1 mit 1', 6', 9', 11' und 12' bezeichnet. Die Zündung einer solchen Struktur erfolgt längs eines zur Achse 21 konzentrischen Kreises, der die Punkte 16 und 16' enthält.

Andererseits kann die Linie 21 in Fig. 1 auch als eine senkrecht zur Bildebene stehende Symmetrieebene aufgefasst werden. Dabei weisen die Teile 1, 6, 9, 11 und 12 zweckmäßigerweise eine langgestreckte Form auf und verlaufen mit ihren größeren Abmessungen senkrecht zur Zeichenebene, und zwar vorzugsweise über den ganzen Thyristorquerschnitt. Die Teile 1', 6', 9', 11' und 12' stellen dann analoge Teilstrukturen auf der anderen Seite der Symmetrieebene dar, die bezüglich der letzteren symmetrisch zu den Teilen 1, 6, 9, 11 und 12 liegen. Die Gates 11 und 11' sind in diesem Fall zum Zwecke einer gemeinsamen Ansteuerung miteinander verbunden, was durch eine eingezeichnete Leitung 22 angedeutet ist, und können an den Anschluß 20 geführt sein. Die Kathode 6' ist mit der Kathode 6 verbunden, was durch eine Leitung 23 angedeutet ist.

Die Teile 1, 6, 9, 11 und 12 können auch streifenartig ausgebildet sein und an der Grenzfläche 8 des Thyristors in Form eine Spirale oder in einer anderen Kurvenform angeordnet sein.

Bei dem in Fig. 2 dargestellten Ausführungsbeispiel ist ein anschaltbarer n-Emitter 24 vorgeshen, der an die Stelle des anschaltbaren n-Emitters 9 von Fig. 1 tritt und die gleichen äußeren Abmessungen gegenüber der p-Basis 2 aufweist wie dieser. Es ist an den Randzonen einer grabenförmigen Ausnehmung 25 der Basis 2 vorgesehen, wobei er sich ausgehend vom Rand derselben nur wenige µm, z. B. 5 µm, tief in die p-Basis 2 erstreckt, Dabei wird das n-leitende Gebiet 24 durch Diffusion oder Implantation von Donatoren erzeugt, während die Ausnehmung 25 vorzugsweise durch Ätzung hergestellt wird. Die übrigen Schaltungsteile von Fig. 2 entspechen den gleichbezeichneten Schaltungsteilen von Fig. 1.

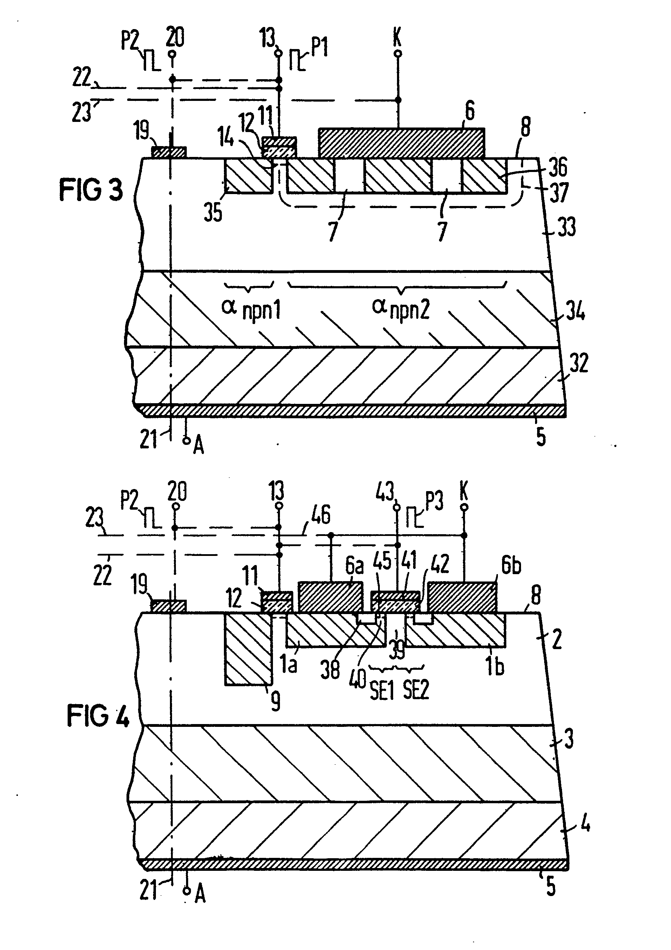

In Fig. 3 ist ein Thyristor mit einem p-Emitter 32, einer n-Basis 34 und einer p-Basis 33 dargestellt. Ein anschaltbarer n-Emitter 35 tritt hierbei an die Stelle des anschaltbaren n-Emitters 9 von Fig. 1 und weist die gleichen lateralen Abmessungen gegenüber der p-Basis 33 auf wie das Teil 9 gegenüber der p-Basis 2.Mit 36 ist ein n-Emitter bezeichnet, die an die Stelle des n-Emitters 1 von Fig. 1 tritt und die gleichen lateralen Abmessungen aufweist wie dieser. Die vertikalen Abmessungen der Teile 35 und 36 sind einander angeglichen, wobei sie zweckmäßigerweise größer sind als die vertikalen Abmessungen des n-Emitters 1 und beispielsweise denen der Teile 9 und 9' in Fig. 1 entsprechen. Die übrigen Schaltungsteile von Fig. 3 entsprechen den mit gleichen Bezugszeichen versehenen Schaltungsteilen von Fig. 1.

Der n-Emitter 36 ist von einem Teilbereich 37 der p-Basis 33 umgeben, der eine zusätzliche p-Dotierung aufweist, so daß sein Dotierungsgrad höher ist als der der übrigen Teilbereiche der p-Basis 33. Das hat zur Folge, daß die aus den Teilen 36, 33 und 34 bestehende Drei-Schichten-Struktur einen Stromverstärkungsfaktor $\alpha_{npn2}$ bezüglich der von dem n-Emitter 36 im Falle einer bei A und K in Durchlaßrichtung des Thyristors angelegten Spannung emitterten Elektronen aufweist, der kleiner ist als der entsprechende Stromverstärkungsfaktor $\alpha_{npn1}$ der Drei-Schichten-Struktur 35, 33 und 34 bezüglich der von dem Gebiet 35 emitterten Elektronen. Je stärker sich der Dotierungsgrad des Teilbereichs 37 von dem der übrigen Teilbereiche der p-Basis 33 unterschiedet, desto stärker weichen $\alpha_{npn1}$ und $\alpha_{npn2}$ voneinander ab. Wird dem Anschluß 13 eine Steuerspannung, z. B. P1 zugeführt, die es bewirkt, daß die Gebiete 35 und 36 über den mit 14 angedeuteten Inversionskanal niederohmig miteinander verbunden werden, so wird der Thyristor im Bereich des anschaltbaren n-Emitters 35 sehr zündempfindlich. Bei Abschaltung der Steuerspannung vom Anschluß 13 ist der anschaltbare n-Emitter 35 unwirksam, so daß der Thyristor wegen der festen Emitterkurzschlüsse 7 und der hohen Dotierung des Teilbereichs 37 eine große Stabilität aufweist. Bei einer Störstellenkonzentration in der p-Basis 33 von etwa $5 \times 10^{16}$ cm$^{-3}$ kommt für den Teilbereich 37 beispielsweise eine Störstellenkonzentration von etwa $2 \times 10^{17}$ cm$^{-3}$ in Betracht, wobei diese Zahlenangaben nur zur Erläuterung des genannten Dotierungsunterschiedes dienen und nicht als Grenzwerte aufzufassen sind.

Unterschiedliche Stromverstärkungsfaktoren $\alpha_{npn1}$ und $\alpha_{npn2}$ lassen sich auch in der Weise erreichen, daß der Teilbereich 37 nicht stärker dotiert wird als die übrigen Teile des p-Emitters 33, sondern stattdessen mit zusätzlichen Rekominationszentren versehen wird. Dies geschieht z. B. durch eine auf den Teilbereich 37 beschränkte Bestrahlung der p-Basis 33 vor dem Erzeugen des n-Emitters 36 mit einem Elektronenstrahl. Andererseits können auch Rekombinationszentren in Form von Gold- oder Platinatomen durch Diffusion oder Implantation in den Teilbereich 37 eingebracht werden. Die Erhöhung der Anzahl der Rekombinationszentren im Teilbereich 37 bewirkt eine Verringerung von $\alpha_{npn2}$ gegenüber $\alpha_{npn1}$.

Die Thyristoren nach den Figuren 2 und 3 werden in derselben Weise betrieben wie der Thyristor nach Fig. 1.

Das in Fig. 4 dargestellte Ausführungsbeispiel unterscheidet sich von Fig. 1 dadurch, daß anstelle der Ansätze 7 steuerbare Emitterkurzschlüsse vorgesehen sind. Der n-Emitter von Fig. 1 ist in zwei oder mehrere Emitterteilgebiete 1a, 1b unterteilt, von denen jedes mit einem Teil 6a bzw. 6b der Kathode versehen ist. Die Teile 6a und 6b sind miteinander verbunden und an einen gemeinsamen Anschluß K geführt.

Ein in Fig. 4 mit SE 1 bezeichneter steuerbarer Emitterkurzschluß weist ein in das Emitterteilgebiet 1a engefügtes, p-leitendes Halbleitergebiet 38 auf, das sich bis zur Grenzfläche 8 des Halbleiterkörpers erstreckt und in dieser von dem Teil 6a der Kathode kontaktiert wird. Die Emitterteilgebiete 1a und 1b sind durch einen Bereich 39 der p-Basis 2 voneinander getrennt, der als ein zweites p-leitendes Halbleitergebiet des steuerbaren Emitterkurzschlusses aufzufassen ist. Zwischen den Gebieten 38 und 39 liegt ein von der Grenzfläche 8 ausgehender Randbereich 40 des Emitterteilgebiets 1a, der n-leitend ist, Letzterer wird von einem Gate 41 überdeckt, das einen Anschluß 43 aufweist und von einer dünnen, elektrisch isolierenden Schicht 42, z. B. aus $SiO_2$, von dem Halbleiterkörper getrennt ist. Die Teile 38 bis 43 bilden eine FET-Struktur des Verarmungstyps, bie der ohne Zuführung einer Steuerspannung an den Anschluß 43 ein p-leitender Kanal 45 in dem Randbereich 40 besteht, der das Gebiet 39 mit dem Gebiet 38 und damit die p-Basis 2 mit dem Teil 6a der Kathode niederohmig verbindet. Der Kanal 45 ist entweder ein Inversionskanal oder ein durch eine p-Dotierung an der Grenzfläche 8 erzeugter, dotierter Kanal. Der Emitterkurzschluß SE1 ist also bei spannungsfreiem Anschluß 43 wirksam geschaltet. Führt man dem Anschluß 43 eine positive Steuerspannung zu, so wird der Kanal 45 beseitigt und die niederohmige Verbindung der Teile 2 und 6a untebrochen, d. h. der Emitterkurzschluß SE1 unwirksam geschaltet.

In Fig. 4 ist randseitig zu dem Emitterteilgebeit 1b ein weiterer steuerbarer Emitterkurzschluß SE2 vorgesehen, der entsprechend SE1 aufgebaut ist, Dabei ist das Gate 41 den Emitterkurzschlüssen SE1 und SE2 gemeinsam zugeordnet. Zweckmäßigerweise ist eine mit 46 bezeichnete, die Anschlüsse 43 und 13 miteinander verbindende Leitung vorgesehen. Die Anschlüsse 13 und 43 können auch einzeln oder gemeinsam mit dem Anschluß 20 verbunden sein. Die übrigen Schaltungsteile von Fig. 4 entsprechen den mit den gleichen Bezugszeichen versehenen Teilen von Fig. 1.

Anstelle der beiden dargestellten Emitterteilgebiete 1a und 1b können bei dem Ausführungsbeispiel von Fig. 4 auch mehrere entsprechend ausgebildete Emitterteilgebiete oder auch nur ein einziges solches Teilgebiet, z. B. 1a oder 1b vorgesehen sein.

Mit dem Ausführungsbeispiel nach Fig. 4 wird eine besonders hohe Stablität erreicht, und zwar insb. dann, wenn eine größere Anzahl von Emitterteilgebieten 1a, 1b... und eine entsprechend große Anzahl von steuerbaren Emitterkurzschlüssen SE1, SE2... vorgeshen sind. Diese werden durch eine zum Zündungszeitpunkt am Anschluß 43 liegende positive Steuerspannung, z. B. impulsförmige Steuerspannung P3, unwirksam geschaltet, so daß die Ausbreitung der gezündeten Front über den gesamten Thyristorquerschnitt durch die Emitterkurzschlüsse nicht behindert wird. Ist der Thyristorquerschnitt im Bereich der Emitterteilgebiete 1a, 1b stromführend geworden, kann die Steuerspannung abgeschaltet werden, wie durch P3 angedeutet ist. Ist ein Anschluß 20 vorgesehen, dem ein Zündstromimpuls P2 zugeführt wird, so fällt bei einer Verbindung der Anschlüsse 43 und 20 an letzterem die Steuerspannung P3 selbsttätig ab. Die Steuerung des Anschlusses 13 erfolgt in der bereits anhand von Fig. 1 erläuterten Weise.

Die bischer beschriebenen FET-Strukturen, z. B. 38 bis 45, des Verarmungstyps können auch durch FET-Strukturen des Anreicherungstyps erstezt sein, wenn ihren Gateanschlüssen, z. B. 43, eine zusätzliche negative Steuerspannung zugeführt wird, die Inversionskanäle, z. B. 45, entstehen läßt. Dieser zusätzlichen Steuerspannung wird dann die Steuerspannung P3 im Zündzeitpunkt überlagert, um die Kanäle aufzuheben.

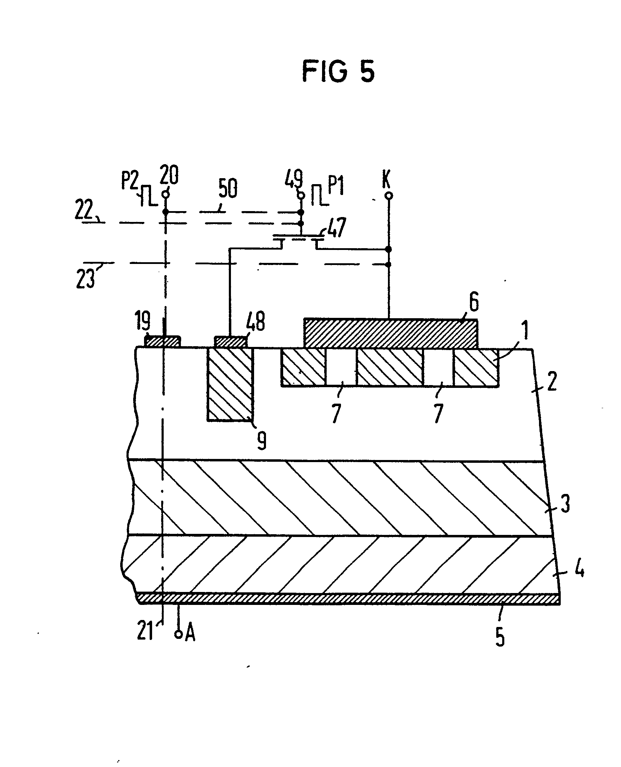

Fig. 5 zeigt eine andere Ansgestaltung des Ausführungsbeispiels nach Fig. 1, bei der der anschaltbare n-Emitter 9 über einen Halbleiterschalter in Form eines externen Feldeffeckttransistors 47 mit dem n-Emitter 1 leitend verbunden wird. Dabei ist die Source-Drain-Strecke von 47 einerseits mit der Kathode 6 und andererseits mit einer lietenden Belegung 48 verbunden, die den anschaltbaren n-Emitter 9 kontaktiert. Das Gate von 47 ist mit einem Steuerspannungsanschluß 49 versehen, der über eine Leitung 50 mit dem Anschluß 20 verbunden sein kann. Der Betrieb des Thyristors nach Fig. 5 erfolgt in der anhand von Fig. 1 beschriebenen Weise, wobei der Anschluß 49 dem Anschluß 13 entspricht und mit der Steuerspannung P1 belegt ist, während dem Anschluß 20 gegebenenfalls ein Zündstromimpuls P2 zugeführt wird.

Im Rahmen der Erfindung kann der anschaltbare Hilfsemitter auch p-leitend sein, lateral neben dem p-Emitter in der n-Basis des Thyristors angeordnet sein und zur Herstellung einer großen Zündempfindlichkeit über einen Halbliieterschalter mit diesem p-Emitter niederohmig verbunden werden. In diesem Fall sind dann auch die festen oder steuerbaren Emitterkurzschlüsse im Bereich des p-Emitters vorgesehen. Sämtliche Figuren können zur Darstellung dieser Schaltungsvariante herangezogen werden, wenn die Bezeichnungen der Anschlüsse A und K miteinander vertauscht werden, die Halbleiterteile jeweils die entgegengesetzten Leitungstypen zu den bisher beschriebenen erhalten und die genannten Steuerspannungen sowie der Steuerstrom mit entgegengesetzter Polarität zugeführt werden.

Sämtliche Ausführungsbeispiele nach den Figuren 2 bis 5 können entsprechend Fig. 1 jeweils zu einer Symmetrieachse 21 zentrisch symmetrische ausgebildet sein oder jeweils zu einer Ebene, die zur Bildebene senkrecht steht und durch 21 angedeutet ist, symmetrische aufgebaut sein. Im letzeren Fall dienen die Leitungen 22 und 23 zur Verbindung gleichartiger, zu 21 symmetrischer Teile.

Die in Fig. 2 dargestellten Teile 1, 6, 11, 12, 24 und 25 können auch streifenartig ausgebildet sein und an der Grenzfläche 8 des Thyristors in Form einer Spirale oder in anderen Kurvenformen angeordnet sein. Gleiches gilt für die Teile 6, 11, 12, 35, 36 und 37 von Fig. 3, 1a, 1b, 6a, 6b, 9, 11, 12, 38 bis 42 von Fig. 4 und 1, 6, 9 und 48 von Fig. 5.

Die Ausführungsbeispiele nach den Figuren 2, 3 und 4 können auch mit einem Halbleiterschalter in Form eines externen Transistors 47 ausgestattet sein. Weiterhin können die anschaltbaren n-Emitter 9 und 35 der Figuren 3 bis 5 entsprechend den Teilen 24, 25 von Fig. 2 ausgebildet sein und die festen Emitter-Anschlüsse 7 in allen Figuren durch steuerbare Emitterkurzschlüsse, z. B. SE1 oder SE2, ersetzt sein.

## Patentansprüche

1. Thyristor mit einem Halbleiterkörper, der einen von einer Kathode (6) kontaktierten n-Emitter (1) mit Emitterkurzschlüssen (7, 45), einen von einer Anode (5) kontaktierten p-Emitter (4) und zwei an diese jeweils angrenzende Basisschichten (2, 3) enthält, dadurch gekennzeichnet, daß lateral neben dem n(p)-Emitter (1) ein anschaltbarer n(p)-Emitter (9) vorgesehen ist, der über einen Halbleiterschalter (11, 12, 14) mit dem n(p)-Emitter (1) leitend verbindbar ist, und daß der anschaltbare n(p)-Emitter (9) mit den beiden Basisschichten (2, 3) eine Drei-Schichten-Struktur abwechselnden Leitungstyps bildet, deren im leitenden Zustand des Halbleiterschalters (11, 12, 14) und bei positiver Vorspannung der Anode (5) gegenüber der Kathode (6) für die von dem anschaltbaren n(p)-Emitter (9) emittierten Ladungsträger bestehender Stromverstärkungsfaktor ($\alpha_{npn1}$) größer ist als der entsprechende Stromverstärkungsfaktor ($\alpha_{npn2}$) der Drei-Schichten-Struktur, die aus dem n(p)-Emitter (1) und den beiden Basisschichten (2, 3) gebildet ist.

2. Thyristor nach Anspruch 1, dadurch gekennzeichnet, daß der Abstand (D1) des anschaltbaren n(p)-Emitters (9) von dem zwischen den beiden Basisschichten (2, 3) bestehenden pn-Übergang kleiner ist als der Abstand (D2) des n(p)-Emitters (1) von diesem pn-Übergang.

3. Thyristor nach Anspruch 1, dadurch gekennzeichnet, daß der n(p)-Emitter (36) von einem Teilbereich (37) der angrenzenden Basisschicht (33) umgeben ist, dessen Dotierungsgrad höher ist als der Dotierungsgrad des Teilbereiches dieser Basisschicht (33), der den anschaltbaren n(p)-Emitter (35) umgibt.

4. Thyristor nach Anspruch 1, dadurch gekennzeichnet daß der n(p)-Emitter (36) von einem Teilbereich (37) der angrenzenden Basisschicht (33) umgeben ist, der eine größere Anzahl von Rekombinationszentren pro Raumeinheit aufweist als der Teilbereich dieser Basisschicht (33), der den anschaltbaren n(p)-Emitter (35) umgibt.

5. Thyristor nach einem der vorhergehenden Ansprüche, dadurch gekennzeichnet, daß der Halbleiterschalter aus einem Feldeffekttransistor besteht, der einen Randbereich des anschaltbaren n(p)-Emitters (9) einen Randbereich des n(p)-Emitters (1) und einen diese beiden Randbereiche voneinander trennenden Bereich (10) der angrenzenden Basisschicht (2) umfaßt, wobei der letztere Bereich (10) von einem gegenüber dem Halbleiterkörper elektrisch isolierten Gate (11) überdeckt ist, das mit einem ersten Steuerspannungsanschluß (13) versehen ist.

6. Thyristor nach einem der Ansprüche 1 bis 4, dadurch gekennzeichnet, daß der Halbleiterschalter aus einem externen Feldeffekttransistor (47) besteht, dessen Source- und Drainanschlüsse mit dem n(p)-Emitter (1) und dem anschaltbaren n(p)-Emitter (9) leitend verbunden sind und dessen Gate mit einem zweiten Steuerspannungsanschluß (49) versehen ist.

7. Thyristor nach einem der vorhergehenden Ansprüche, dadurch gekennzeichnet, daß der anschaltbare n(p)-Emitter aus einem Gebiet (24) des Halbleiterkörpers besteht, das eine in einer Basisschicht (2) vorgesehene, von der Grenzfläche des Halbleiterkörpers ausgehende Ausnehmung (25) umgibt und einen zu dieser Basisschicht (2) entgegengesetzten Leitungstyp aufweist.

8. Thyristor nach einem der vorhergehenden Ansprüche, dadurch gekennzeichnet, daß der n(p)-Emitter (1a, 1b) mit wenigstens einem als FET-Struktur ausgebildeten, steuerbaren Emitterkurzschluß versehen ist der ein mit der Kathode (Anode) (6a) Verbundenes, erstes halbleitergebiet (38) eines ersten Leitungstyps, ein mit der an den anschaltbaren n(p)-Emitter (9) angrenzenden Basisschicht (2) verbundenes zweites Halbleitergebiet (39) des ersten Leitungstyps und ein zwischen diesen Gebieten liegendes weiteres Halbleitergebiet (40) aufweist, und daß das weitere Halbleitergebiet (40) von einem gegenüber dem Halbleiterkörper elektrisch isolierten Gate (41) überdeckt ist, das mit einem dritten Steuerspannungsanschluß (43) versehen ist.

9. Thyristor nach einem der vorhergehenden Ansprüche, dadurch gekennzeichnet, daß die an den n(p)-Emitter (1, 1a, 1b, 36) angrenzende Basisschicht (2, 33) mit einer Zündelektrode (19) versehen ist, die einen Anschluß (20) für einen Zündstromkreis aufweist.

10. Thyristor nach einem der Ansprüche 5, 6 oder 8 und nach Anspruch 9, dadurch gekennzeichnet, daß der Anschluß (20) für den Zündstromkreis mit wenigstens einem der Steuerspannungsanschlüsse (13, 43, 49) verbunden ist.

11. Thyristor nach einem der vorhergehenden Ansprüche, dadurch gekennzeichnet, daß die Anode (5) und Kathode (6, 6a, 6b) auf einander gegenüberliegen Grenzflächen des Halbleiterkörpers angeordnet sind.

12. Verfharen zum Betrieb eines Thyristors nach einem der vorhergehenden Ansprüche, dadurch gekennzeichnet, daß zum Zünden desselben der Halbleiterschalter (1, 9, 11, 12; 47) leitend geschaltet wird.

13. Verfahren nach Anspruch 12, dadurch gekennzeichnet daß zum Zünden des Thyristors dem Steuerspannungsanschluß (13, 49) des Halbleiterschalters bei einer Ausbildung desselben als n(p)-Kanal-Feld-effekttransistor des Anreicherungstyps und ggf. dem Steuerspannungsschluß (43) des steuerbaren Emitterkurzschlusses bei einer Ausbildung desselben als n(p)-Kanal-FET-Struktur des Verarumungstyps jeweils ein positiver (negativer) Spannungsimpuls (P1, P3) zugeführt wird.

**Claims**

1. A thyristor comprising a semiconductor body which contains a n-emitter (1) which is contacted by a cathode (6) and is provided with emitter short-circuits (7, 45) a p-emitter (4) which is contacted by an anode (5), and two base layers (2, 3) which respectively adjoin said emitters, characterised in that laterally to the n(p)-emitter (1) a switchable n(p)-emitter (9) is provided which can be conductively connected through a semiconductor switch (11, 12, 14) to the n(p)-emitter (1); and that the switchable n(p)-emitter (9) forms, with the two base layers (2, 3) a three-layer structure of alternating conductivity type, whose current amplification factor ($a_{npn1}$) for the charge carriers emitted from the switchable n(p)-emitter (9) when the semiconductor switch (11, 12, 14) is in the conductive state and the bias voltage of the anode (5) is positive with respect to the cathode (6), is greater than the corresponding current amplification factor ($a_{npn2}$) of the three-layer structure which consists of the n(p)-emitter (1) and the two-base layers (2, 3).

2. A thyristor as claimed in Claim 1, characterised in that the distance (D1) of the switchable n(p)-emitter (9) from the pn-junction between the two base layers (2, 3), is shorter than the distance (D2) of the n(p)-emitter (1) from this pn-junction.

3. A thyristor as claimed in Claim 1, characterised in that the n(p)-emitter (36) is surrounded by a sub-zone (37) of the adjacent base layer (33), the doping level of said sub-zone being higher than the doping level of that sub-zone of the base layer (33) which surrounds the switchable n(p)-emitter (35).

4. A thyristor a claimed in Claim 1, characterised in that the n(p)-emitter (36) is surrounded by a sub-zone (37) of the adjacent base layer (33) which contains a larger number of recombination centres per unit of space than does that sub-zone of the base layer (33) which surrounds the switchable n(p)-emitter (35).

5. A thyristor as claimed in one of the preceding Claims, characterised in that the semiconductor switch consists of a field effect transistor which comprises an edge zone of the switchable n(p)-emitter (9), an edge zone of the n(p)-emitter (1), and a zone (10) (which separates these two edge zones from one another) of the adjacent base layer (2), the zone (10) being covered by a gate (11) which is electrically insulated with respect to the semiconductor body and is provided with a first control voltage terminal (13).

6. A thyristor as claimed in one of Claims 1 to 4, characterised in that the semiconductor switch consists of an external field effect transistor (47), the source and drain terminals of which are conductively connected to the n(p)-emitter (1) and to the switchable n(p)-emitter (9) and whose gate is provided with a second control voltage terminal (49).

7. A thyristor as claimed in one of the preceding Claims, characterised in that the switchable n(p)-emitter consists of a zone (24) of the semiconductor body which surrounds a recess (25) which is provided in a base layer (2) and which starts from the boundary surface of the semiconductor body, and which zone has the conductivity type which is the opposite to that of the base layer (2).

8. A thyristor as claimed in one of the preceding Claims, characterised in that the n(p)-emitter (1a, 1b) is provided with at least one controllable emitter short-circuit which has a FET-structure and which comprises a first semiconductor zone (38) of a first conductivity type which is connected to the cathode (anode) (6a), a second semiconductor zone (39) of the first conductivity type which is connected to the base layer (2) which adjoins the switchable n(p)-emitter (9), and a further semiconductor zone (4) which is arranged between these zones; and that the further semiconductor zone (40) is covered by a gate (41) which is electrically insulated with respect to the semiconductor body and is provided with a third control voltage terminal (43).

9. A thyristor as claimed in one of the preceding Claims, characterised in that the base layer (2, 33) which adjoins the n(p)-emitter (1, 1a, 1b, 36) is provided with an ignition electrode (19) which has a terminal (20) for an ignition circuit.

10. A thyristor as claimed in one of Claims 5, 6 or 8 and 9, characterised in that the terminal (20) for the ignition circuit is connected to at least one of the control voltage terminals (13, 43, 49).

11. A thyristor as claimed in one of the preceding Claims characterised in that the anode (5) and cathode (6, 6a, 6b) are arranged on opposite boundary surfaces of the semiconductor body.

12. A method of operating a thyristor as claimed in one of the preceding Claims, characterised in that in order to ignite the thyristor, the semiconductor switch (1, 9, 11, 12; 47) is switched to be conductive.

13. A method as claimed in Claim 12, characterised in that in order to ignite the thyristor, a positive (negative) voltage pulse (P1, P3) is supplied to the control voltage terminal (13, 49) of the semiconductor switch when the latter represents a n(p)-channel field effect transistor of the enhancement type and possibly to the control voltage terminal (43) of the controllable emitter short-circuit when the latter has a n(p)-channel-FET-structure of the depletion type.

## Revendications

1. Thyristor possédant un corps semi-conducteur qui contient un émetteur n (1) pourvu de courts-circuits d'émetteur (7, 45) et un émetteur p (4) avec lequel une anode (5) est mise en contact, ainsi que deux couches de base (2, 3) adjacentes chacune à l'un de ces émetteurs, caractérisé en ce qu'il comprend, latéralement à côté de l'émetteur n(p) (1), un émetteur n(p) connectable (9) qui peut être connecté par un interrupteur à semi-conducteur (11, 12, 14) à l'émetteur n(p) (1), et que l'émetteur n(p) connectable (9) constitue avec les deux couches de base (2, 3) une structure à trois couches de types de conductivité alternées, dont le facteur d'amplification du courant $(\alpha_{npn1})$ pour les porteurs de charge émis par l'émetteur n(p) connectable (9) est plus grand, lorsque l'interrupteur à semi-conducteur (11, 12, 14) est à l'état conducteur et l'anode (5) est polarisée positivement par rapport à la cathode (6), que le facteur d'amplification du courant $(\alpha_{npn1})$ correspondant de la structure à trois couches constituée de l'émetteur n(p) (1) et des deux couches de base (2, 3).

2. Thyristor selon la revendication 1, caractérisé en ce que la distance (D1) de l'émetteur n(p) connectable (9) à la jonction pn existant entre les deux couches de base (2, 3) est plus petite que la distance (D2) de l'émetteur n(p) (1) à cette jonction pn.

3. Thyristor selon la revendication 1, caractérisé en ce que l'émetteur n(p) (36) est entouré d'une région partielle (37) de la couche de base (33) adjacente, dont le degré de dopage est plus élevé que le degré de dopage de la région partielle de cette couche de base (33) entourant l'émetteur n(p) connectable (35).

4. Thyristor selon la revendication 1, caractérisé en ce que l'émetteur n(p) (36) est entouré d'une région partielle (37) de la couche de base (33) adjacente, qui présente un plus grand nombre de centres de recombinaison par unité de volume que la région partielle de cette couche de base (33) entourant l'émetteur n(p) connectable (35).

5. Thyristor selon une des revendications précédentes, caractérisé en ce que l'interrupteur à semiconducteur est formé d'un transistor à effet de champ qui comprend une zone marginale de l'émetteur n(p) connectable (9), une zone marginale de l'émetteur n(p) (1) et une zone (10) séparant ces deux zones marginales et faisant partie de la couche de base (2) adjacente, cette dernière zone (10) étant recouverte par une grille (11) électriquement isolée du corps semi-conducteur et pourvue d'une première borne de tension de commande (13).

6. Thyristor selon une des revendications 1 à 4, caractérisé en ce que l'interrupteur à semi-conducteur est formé d'un transistor à effet de champ (47) externe dont les bornes de source et de drain sont connectées à l'émetteur n(p) (1) et à l'émetteur n(p) connectable (9) et dont la grille est pourvue d'une seconde borne de tension de commande (49).

7. Thyristor selon une des revendications précédentes, caractérisé en ce que l'émetteur n(p) connectable est formé d'une zone (24) du corps semi-conducteur, qui entoure un évidement (25) prévu dans la couche de base (2) et s'étendant à partir de la surface limite du corps semi-conducteur, et qui présente un type de un type de conductivité contraire à celui de cette couche de base (2).

8. Thyristor selon une des revendications précédentes, caractérisé en ce que l'émetteur n(p) (1a, 1b) est pourvu d'au moins un court-cicuit d'émetteur commandé, réalisé comme une structure FET, qui présente une première zone de semi-conducteur (38) reliée à la cathode (anode) (6a), d'un premier type de conductivité, une deuxième zone de semi-conducteur (39), du premier type de conductivité, qui est reliée à la couche de base (2) adjacente à l'émetteur n(p) connectable (9), de même qu'une zone de semi-conducteur supplémentaire (40) située entre ces zones, et que la zone de semi-conducteur supplémentaire (40) est recouverte par une grille (41) qui est isolée électriquement vis-à-vis du corps semi-conducteur et qui est pourvue d'une troisième borne de tension de commande (43).

9. Thyristor selon une des revendications précédentes, caractérisé en ce que la couche de base (2, 33) adjacente à l'émetteur n(p) (1, 1a, 1b, 36) est pourvue d'une électrode d'amorçage (19) qui présente une borne (20) pour un circuit d'amorçage.

10. Thyristor selon une des revendications 5, 6 ou 8 et la revendication 9, caractérisé en ce que la borne (20) pour le circuit d'amorçage est connectée à l'une au moins des bornes de tension de commande (13, 43, 49).

11. Thyristor selon une des revendications précédentes, caractérisé en ce que l'anode (5) et la cathode (6, 6a, 6b) sont disposées sur des surfaces limites mutuellement opposées du corps semi-conducteur.

12. Procédé pour faire fonctionner un thyristor selon une des revendications précédentes, caractérisé en ce que, pour amorcer le thyristor, l'interrupteur à semi-conducteur (1, 9, 11, 12; 47) est commuté à l'état conducteur.

13. Procédé selon la revendication 12, caractérisé en ce que, pour amorcer le thyristor, une impulsion de tension positive (négative) (P1, P3) est apliquée à la borne de tension de commande (13, 49) de l'interrupteur à semi-conducteur, en cas de réalisation de celui-ci comme un transistor à effet de champ à canal n(p), due type à enrichissement, et, éventuellement, à la borne de tension de commande (43) du court-circuit d'émetteur commandé, en cas de réalisation de celui-ci comme une structure FET à canal n(p) du type à appauvrissement.

FIG 1

FIG 2

FIG 3

FIG 4

$\alpha_{npn1}$ $\alpha_{npn2}$

# FIG 5